Europäisches Patentamt

European Patent Office

Office européen des brevets

(11) Veröffentlichungsnummer : **0 072 938**
**B1**

(12) **EUROPÄISCHE PATENTSCHRIFT**

(45) Veröffentlichungstag der Patentschrift :
03.12.86

(51) Int. Cl.⁴ : **H 01 L 21/268,** H 01 L 21/58,
H 01 L 21/60

(21) Anmeldenummer : 82106929.1

(22) Anmeldetag : 30.07.82

(54) Verfahren zum Verbinden eines Halbleiterchips mit einem Chipträger.

(30) Priorität : 20.08.81 DE 3132983

(43) Veröffentlichungstag der Anmeldung :
02.03.83 Patentblatt 83/09

(45) Bekanntmachung des Hinweises auf die Patenterteilung : 03.12.86 Patentblatt 86/49

(84) Benannte Vertragsstaaten :
CH DE FR GB IT LI

(56) Entgegenhaltungen :
EP-A- 0 046 914
DE-A- 875 968
DE-A- 1 414 425
GB-A- 2 022 316
IBM TECHNICAL DISCLOSURE BULLETIN, Band 17,
Nr. 12, Mai 1975, Seite 3544, New York, US; R.W.
NOTH: "Heat transfer from silicon chips and wafers"
JOURNAL OF THE ELECTROCHEMICAL SOCIETY,
Band 126, Nr. 8, August 1979, Seiten 1436-1437,
Princeton, US; C.W. PEARCE et al.: "A new approach
to lattice damage gettering"

(73) Patentinhaber : Siemens Aktiengesellschaft Berlin
und München
Wittelsbacherplatz 2
D-8000 München 2 (DE)

(72) Erfinder : Badalec, Radim
Geigenbergerstrasse 5
D-8000 München 71 (DE)
Erfinder : Baumgartner, Werner
Rossinistrasse 12
D-8000 München 40 (DE)
Erfinder : Cutter, David, Dr.rer.nat.
Zehntfeldstrasse 117
D-8000 München 82 (DE)

Anmerkung : Innerhalb von neun Monaten nach der Bekanntmachung des Hinweises auf die Erteilung des
europäischen Patents im Europäischen Patentblatt kann jedermann beim Europäischen Patentamt gegen das erteilte
europäische Patent Einspruch einlegen. Der Einspruch ist schriftlich einzureichen und zu begründen. Er gilt erst als
eingelegt, wenn die Einspruchsgebühr entrichtet worden ist (Art. 99(1) Europäisches Patentübereinkommen).

## Beschreibung

Die Erfindung bezieht sich auf ein Verfahren zum Verbinden eines Halbleiterchips mit einem Chipträger durch Kleben oder Löten.

Halbleiterchips, wie z. B. integrierte Halbleiterschaltungen oder Leistungsbauelemente, werden einseitig auf metallenen Trägerplatten oder metallisierten Keramikträgerplatten aufgelötet oder aufgeklebt. Die Löt- bzw. Klebstelle muß mechanisch so dauerhaft sein, daß sie durch häufige Lastwechsel und damit verbundene Scherspannungen zwischen Halbleiterchip und Chipträger nicht zerstört wird. Da der Chipträger außerdem noch entweder selbst als Kühlkörper dient oder aber die Wärme zu einem Kühlkörper ableiten muß, ist auch ein möglichst geringer, reproduzierbarer thermischer Übergangswiderstand zwischen dem Halbleiterchip und dem Chipträger anzustreben.

Der Erfindung liegt die Aufgabe zugrunde, ein Verfahren der oben angegebenen Art anzugeben, mit dem eine optimale Haltbarkeit der Verbindungsstelle bei gleichzeitig niedrigem und reproduzierbaren thermischen Übergangswiderstand erreicht werden kann.

Die Erfindung ist dadurch gekennzeichnet, daß die zu verbindende Fläche des Halbleiterchips mittels eines Laserstrahls behandelt wird und daß die Energie des Laserstrahls so eingestellt wird, daß durch örtliches Aufschmelzen des Halbleitermaterials Vertiefungen erzeugt werden und das geschmolzene Halbleitermaterial wenigstens teilweise am Rand der Vertiefung aufgeworfen wird.

Weiterbildungen der Erfindung sind Gegenstand der Unteransprüche.

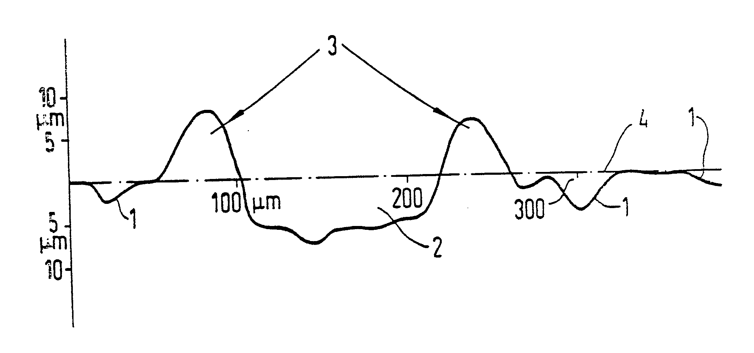

Die Erfindung wird an Hand einiger Verfahrensparameter in Verbindung mit der Figur näher erläutert :

Die Halbleiterchips werden nach den üblichen Verfahrensschritten wie Implantieren, Diffundieren, Ätzen usw. an der mit dem Chipträger zu verbindenden Seite mit einem Laserstrahl behandelt. Dieser Laserstrahl stammt beispielsweise von einem gepulsten Nd : YAG-Laser (Neodym : Yttrium-Aluminium-Granat). Die dem Laser zugeführte Energie wird so eingestellt, daß der Laserstrahl auf der Oberfläche der Halbleiterscheibe, z. B. einer Silicium-Halbleiterscheibe, Krater von 2 bis 10 µm Tiefe erzeugt. Der Durchmesser der Krater kann z. B. zwischen 50 und 200 µm liegen. Dieses Ergebnis läßt sich mit einer dem Laser zugeführten Leistung von rund 50 W und einer Frequenz von rund 4 kHz erzielen. Trifft der Laser auf die Siliciumoberfläche, so schmilzt Silicium auf und wird aus dem Krater herausgeschleudert. Dabei bildet sich rings um den Krater ein Aufwurf von ebenfalls etwa 2 bis 10 µm. Das Aufschmelzen kann unter Schutzgas wie Argon, Stickstoff oder unter Reaktivgas wie Sauerstoff erfolgen.

Der sich ergebende Querschnitt durch einen solchen Krater ist in der Figur dargestellt. Dabei ist die Kontur der erhalten gebliebenen Siliciumoberfläche mit 1 bezeichnet. Der entstandene Krater trägt die Bezugsziffer 2, während der Aufwurf am Rand der Vertiefung mit 3 bezeichnet ist. Die Tiefe der Vertiefung und die Höhe des Aufwurfs sind dabei von einer gedachten Linie 4 aus gemessen, die über die Maxima der ursprünglichen Siliciumoberfläche gelegt wird. Die Breite bzw. der Durchmesser der Vertiefung soll auf der Höhe der gedachten Ebene gemessen werden.

Zur Erzielung einer guten Verbindung zwischen Halbleiterchip und Chipträger sollte das Verhältnis der Fläche aller Vertiefungen 2 zur Fläche des nicht durch Laser behandelten Halbleiterchips mindestens bei 30 % liegen. Damit wird eine gute Verkrallung des Lots oder des Klebers mit der Oberfläche des Halbleiterchips und eine gute Verbindung zwischen Halbleiterchip und Chipträger erreicht. Der Aufwurf 3 sorgt für einen definierten Abstand zwischen Halbleiterchip und Chipträger, so daß der thermische Übergangswiderstand genau reproduzierbar ist. Die verbleibenden Hohlräume zwischen Halbleiterchip und Chipträger werden dann mit dem leitfähigen Kleber oder mit dem Lot ausgefüllt. Zweckmäßigerweise wird die gesamte zu verbindende Fläche des Halbleiterchips vor dem Verlöten oder Verkleben metallisiert. Damit läßt sich der thermische Übergangswiderstand verringern und der elektrische Kontakt verbessern.

## Patentansprüche

1. Verfahren zum Verbinden eines Halbleiterchips mit einem Chipträger durch Kleben oder Löten, dadurch gekennzeichnet, daß die zu verbindende Fläche des Halbleiterchips mittels eines Laserstrahls behandelt wird und daß die Energie des Laserstrahls so eingestellt wird, daß durch örtliches Aufschmelzen des Halbleitermaterials Vertiefungen (2) erzeugt werden und das geschmolzene Halbleitermaterial wenigstens teilweise am Rand der Vertiefung aufgeworfen wird.

2. Verfahren nach Anspruch 1, dadurch gekennzeichnet, daß die Vertiefungen (2) einen Durchmesser von 50 bis 200 µm und eine Tiefe von 2 bis 10 µm haben und daß das aufgeworfene Halbleitermaterial (3) eine Höhe von 2 bis 10 µm hat.

3. Verfahren nach Anspruch 1 oder 2, dadurch gekennzeichnet, daß ein gepulster Nd : YAG-Laser verwendet wird.

4. Verfahren nach einem der Ansprüche 1 bis 3, dadurch gekennzeichnet, daß das Aufschmelzen unter Verwendung von Schutzgas oder reaktivem Gas erfolgt.

5. Verfahren nach einem der Ansprüche 1 bis 4, dadurch gekennzeichnet, daß die Oberfläche nach der Laserbehandlung metallisiert wird.

## Claims

1. A method of connecting a semiconductor chip to a chip carrier by sticking or soldering, characterised in that the surface of the semiconductor chip to be connected is treated with a laser beam ; and that the energy of the laser beam is so adjusted that recesses (2) are formed by local melting of the semiconductor material and the molten semiconductor material is, at least in part, thrown-up at the edge of the recess.

2. A method as claimed in Claim 1, characterised in that the recesses (2) have a diameter of 50 to 200 $\mu$m and a depth of 2 to 10 $\mu$m , and that the thrown-up semiconductor material (3) has a height of 2 to 10 $\mu$m.

3. A method as claimed in Claim 1 or Claim 2, characterised in that a pulsed Nd : YAG-laser is used.

4. A method as claimed in one of Claims 1 to 3, characterised in that the melting is carried out using a shielding gas or a reactive gas.

5. A method as claimed in one of Claims 1 to 4, characterised in that the surface is metallized after the laser treatment.

**Revendications**

1. Procédé pour raccorder une microplaquette à semiconducteurs à un support de microplaquettes par collage ou soudage, caractérisé par le fait qu'on traite la surface de liaison de la microplaquette à semiconducteurs au moyen d'un faisceau laser et qu'on règle l'énergie du faisceau laser de manière à produire des renfoncements (2) par fusion locale du matériau semiconducteur et qu'on refoule le matériau semiconducteur fondu au moins partiellement sur le bord du renfoncement.

2. Procédé suivant la revendication 1, caractérisé par le fait que les renfoncements (2) possèdent un diamètre compris entre 50 et 200 $\mu$m et une profondeur comprise entre 2 et 10 $\mu$m, et que le matériau semiconducteur refoulé (3) possède une hauteur comprise entre 2 et 10 $\mu$m.

3. Procédé suivant la revendication 1 ou 2, caractérisé par le fait qu'on utilise un laser Nd : YAG pulsé.

4. Procédé suivant l'une des revendications 1 à 3, caractérisé par le fait que la fusion est réalisée moyennant l'utilisation d'un gaz neutre ou d'un gaz réactif.

5. Procédé suivant l'une des revendications 1 à 4, caractérisé par le fait qu'après le traitement au laser, on dépose une métallisation sur la surface.

3

4   1

10
$\mu$m
5

100 $\mu$m   200   300

5
$\mu$m
10

1   2   1